# EUROPEAN PATENT SPECIFICATION

(11) **EP 4 638 603 B1**
(45) Date of publication and mention of the grant of the patent: **19.08.2026**
(21) Application number: 22851383.4
(22) Date of filing: 23.12.2022
(51) Int. Cl.: C08L 83/04, H10W 40/25

(54) **METHOD OF MAKING CURABLE THERMALLY CONDUCTIVE COMPOSITION**
VERFAHREN ZUR HERSTELLUNG EINER HÄRTBAREN WÄRMELEITENDEN ZUSAMMENSETZUNG
PROCÉDÉ DE FABRICATION D'UNE COMPOSITION THERMOCONDUCTRICE DURCISSABLE

(43) Date of publication of application: 29.10.2025
(73) Proprietor: Dow Silicones Corporation, Midland, Michigan 48686 (US)
(72) Inventor: ZHENG, Yan, Shanghai 201203 (CN); CHEN, Chen, Shanghai 201203 (CN); BHAGWAGAR, Dorab Edul, Auburn, Michigan 48611 (US); HANSEN, Darren Michael, Midland, Michigan 48642 (US); ZHU, Junmin, Shanghai 201203 (CN); WEI, Peng, Shanghai 201203 (CN); HONG, Debo, Shanghai 201203 (CN)
(74) Representative: Beck Greener LLP
(86) International application number: PCT/CN2022/141389
(87) International publication number: WO 2024/130698

(56) References cited:
- US-A1- 2020 354 574

## Description

### FIELD

The present invention relates to a method of making a curable thermally conductive composition and a thermally conductive composition made therefrom.

### INTRODUCTION

An industry drive to smaller and more powerful electronic devices has increased demands on thermally conductive compositions useful for dissipating heat generated in such devices. For example, the telecommunications industry is transitioning to the 400 Gigabit Ethernet (GbE) standard for faster switching and routing, which demands optical components such as optical transceivers and other optical modules with better thermal control to remove heat. Thermally conductive interface materials are often used in electronics to thermally couple heat generating components and heat dissipating components.

A challenge with thermally conductive interface materials is to provide a combination of thermal conductivity properties and little or no oil bleeding while being easily extrudable so as to allow precise application of thermally conductive materials on small components. Oil bleeding (also known as "bleed-out" or "flow separation") from thermally conductive interface materials, especially from thermal conductive gels, is a key risk for electronic and optical modules applications, as it causes many problems such as contact failure, contamination, and short circuit, which result in a decline in electronic component reliability and/or impacted optical signal transmission. For instance the document US 2020/354574 A1 discloses a curable thermally conductive composition comprising Q-branched alkenyl-functional polyorganosiloxane having at least three terminally alkenyl groups per molecule, a silyl-hydride functional polysiloxane crosslinker that contains at least two silyl-hydride groups per molecule, thermally conductive fillers (alumina) and a filler treating agent (silane).

Conventionally fabricated thermally conductive pads that are solid materials have no concern of oil bleeding due to the degree of crosslinking, but are not extrudable. These thermally conductive pads have to be applied manually and cannot meet the requirements of high-volume automated process. Moreover, stress applied to improve interface adhesion between thermally conductive pads and electronic components may cause potential damages to dedicate electronic components. Dispensable thermally conductive gels that are liquid at room temperature (25 degrees Celsius (°C)) with properties similar to greases have many advantages over thermally conductive pads, including little or no stress required for assembly at a manufacture plant of the electronic devices, and higher extrusion rate by automated equipment with higher efficiency. However, these dispensable thermally conductive gels typically suffer from severe oil bleeding over time caused by migration of polysiloxane fluids, for example, an oil bleeding degree of more than 10% when the gels are applied at a thick bondline (>1 mm) at room temperature, especially during high-temperature ageing when electronic devices are in operation. In particular, it is more challenging for a one-part dispensable thermally conductive gel to achieve an oil bleeding degree of no more than 10% both at 25 °C for 5 days and after aging at 125 °C for 2 days, while having an extrusion rate (ER) of at least 15 grams per minute and providing a cured material that has a thermal conductivity of greater than 3.0 Watts per meter*Kelvin as measured according to ISO 22007-2 using a hot disk. Oil bleeding degree and ER are measured using the Oil Bleeding Test and Extrusion Rate Test defined herein below, respectively.

There remains a need to identify a thermally conductive composition that can simultaneously achieve the above described oil bleeding degree without compromising extrusion rate and thermal conductivity properties.

### SUMMARY

The present invention provides a curable thermally conductive composition that has an oil bleeding degree of no more than 10% (≤ 10%) after being applied at 25 °C for 5 days and after aging at 125 °C for 2 days, respectively, and an extrusion rate ("ER") of 15 grams per minute (g/min) or more as measured using the Extrusion Rate Test defined herein below and that cures to a material that has a thermal conductivity ("TC") of greater than 3.0 Watts per meter*Kelvin (W/m*K) according to ISO 22007-2 using a hot disk. Surprisingly, it has been determined such a composition can be prepared from a method which involves a pre-curing step using a Q-branched alkenyl-functional polyorganosiloxane (A) and a silyl-hydride functional polysiloxane crosslinker (B1) at specified molar ratios, and further includes addition of a silyl-hydride functional polysiloxane crosslinker (B2).

In a first aspect, the present invention is a method of making a curable thermally conductive composition, comprising the steps of:
(I) preparing an admixture comprising the following components (A), (B1), (C), (D), and (E):
   (A) from 3 weight-percent to 10 weight-percent of a Q-branched alkenyl-functional polyorganosiloxane having at least three terminally alkenyl groups per molecule and having a viscosity of 25 to 2000 millipascal*seconds (mPa*s), as determined according to ASTM D445-21 using a glass capillary Cannon-Fenske type viscometer at 25 °C;
   (B1) a silyl-hydride functional polysiloxane crosslinker that contains at least two silyl-hydride groups per molecule and that is present at a concentration to provide a molar ratio of silicon-bonded hydrogen atoms in (B1) to alkenyl groups in the Q-branched alkenyl-functional polyorganosiloxane in a range of 0.2 to 0.35;
   (C) 90 weight-percent or more of a thermally conductive filler;
   (D) a filler treating agent; and
   (E) a platinum-based hydrosilylation reaction catalyst;
(II) curing the admixture obtained from step (I) by heat, thereby forming a pre-cured composite; and
(III) admixing the pre-cured composite obtained from step (II) with (B2) a silyl-hydride functional polysiloxane crosslinker that contains at least two silyl-hydride groups per molecule; thereby obtaining the curable thermally conductive composition;
   wherein a molar ratio of total silicon-bonded hydrogen atoms in (B1) and (B2) to alkenyl groups in the Q-branched alkenyl-functional polyorganosiloxane (A) is greater than 0.45;
   where weight-percentages are relative to the curable thermally conductive composition weight.

In a second aspect, the present invention is a curable thermally conductive composition, comprising an admixture of a pre-cured composite with (B2) a silyl-hydride functional polysiloxane crosslinker that contains at least two silyl-hydride groups per molecule;
wherein the pre-cured composite comprises component (C), component (D), and a hydrosilylation reaction product of components (A), (B1), and (E):
   (A) from 3 to 10 wt% of a Q-branched alkenyl-functional polyorganosiloxane having at least three terminally alkenyl groups per molecule and having a viscosity of 25 to 2000 mPa*s, as determined according to ASTM D445-21 using a glass capillary Cannon-Fenske type viscometer at 25 °C;
   (B1) a silyl-hydride functional polysiloxane crosslinker that contains at least two silyl-hydride groups per molecule and that is present at a concentration to provide a molar ratio of silicon-bonded hydrogen atoms in (B1) to alkenyl groups in the Q-branched alkenyl-functional polyorganosiloxane (A) of 0.2 to 0.35; and (E) a platinum-based hydrosilylation reaction catalyst;
   (C) 90 weight-percent or more of a thermally conductive filler;
   (D) a filler treating agent; and
   (E) a platinum-based hydrosilylation reaction catalyst;
wherein a molar ratio of total silicon-bonded hydrogen atoms in the silyl-hydride functional polysiloxane crosslinkers (B1) and (B2) to alkenyl groups in the Q-branched alkenyl-functional polyorganosiloxane (A) is greater than 0.45;
where weight-percentages are relative to the curable thermally conductive composition weight;
wherein the curable thermally conductive composition has an extrusion rate of 15 g/min or more and an oil bleeding degree of no more than 10% at 25 °C for 5 days and after aging at 125 °C for 2 days, respectively, and cures into a material having a thermal conductivity of greater than 3.0 W/m*K according to ISO 22007-2 using a hot disk.

In a third aspect, the present invention is a process for forming a thermally conductive silicone material on an electronic component. The process comprises:
(i) providing the curable thermally conductive composition of the second aspect,
(ii) applying the curable thermally conductive composition on the electronic component, and
(iii) curing the curable thermally conductive composition by heat; thereby forming the thermally conductive silicone material.

### DETAILED DESCRIPTION

Test methods refer to the most recent test method as of the priority date of this document when a date is not indicated with the test method number. References to test methods contain both a reference to the testing society and the test method number. The following test method abbreviations and identifiers apply herein: ASTM refers to ASTM International methods and ISO refers to International Organization for Standards.

Products identified by their tradename refer to the compositions available under those tradenames on the priority date of this document.

"And/or" means "and, or as an alternative". All ranges include endpoints unless otherwise indicated. Unless otherwise stated, all weight-percent (wt%) values are relative to composition weight.

"Spherical" shaped particles refer to particles that have an aspect ratio of 1.0 +/- 0.2. Determine the aspect ratio of a particle using scanning electron microscope (SEM) imaging and by taking the average ratio of the longest dimension (major axis) and shortest dimension (minor axis) of at least ten particles.

"Irregular" shaped particles (interchangeable with "crushed" particles) have an aspect ratio other than 1.0 +/- 0.2 and have at least three faces evident by SEM imaging (distinguishing the particles from "platelets", which have 2 faces).

Particle size of thermally conductive fillers (which is used interchangeable with "average particle size" and "D50") refers to the volume-weighted median value of particle diameter distribution (D50) using a Mastersizer^{™} (trademark of Malvern Instruments Limited) 3000 laser diffraction particle size analyzer from Malvern Instruments.

Viscosity of a polysiloxane is determined according to ASTM D445-21 using a glass capillary Cannon-Fenske type viscometer at 25 degrees Celsius (°C) unless otherwise stated.

The present invention relates to a method of making a curable thermally conductive composition (which is used interchangeable with "curable composition"). Such composition can be used as thermally conductive gels, particularly, dispensable thermally conductive gels, and can be dispensed over a heat generating component by automated equipment with minimized stress applied on assemblies for intricate and delicate electronic components. The curable thermally conductive composition is a liquid thermal interface material that cures into gel-like structure by heat such as the heat generated by devices where the composition is applied.

The method of the present invention comprises the steps of: (I) preparing an admixture comprising: components (A), (B1), (C), (D), and (E); (II) curing the admixture obtained from step (I) by heat, thereby forming a pre-cured composite; and (III) admixing component (B2) with the pre-cured composite obtained from step (II); thereby forming the curable thermally conductive composition.

In step (I) of the method, preparation of the admixture can be conducted by admixing components (A), (B1), (C), (D), and (E) in any order. Desirably, components (A), (B1), and (D) are first mixed, and then further mixed with component (C), followed by adding component (E).

Component (A) is a Q-branched alkenyl-functional polyorganosiloxane (hereinafter also referred to as "Q-branched polyorganosiloxane"). "Alkenyl" means a branched or unbranched, monovalent hydrocarbon group having one or more carbon-carbon double bonds. The alkenyl group in the Q-branched polyorganosiloxane is capable of undergoing hydrosilylation reaction. The alkenyl group typically has from 2 to 8 carbon atoms, from 2 to 6 carbon atoms, or from 2 to 4 carbon atoms. Suitable alkenyl groups may include vinyl, allyl, butenyl, and hexenyl.

The Q-branched alkenyl-functional polyorganosiloxane (A) useful in the present invention has at least three terminally alkenyl groups (desirably, vinyl groups) per molecule. The Q-branched alkenyl-functional polyorganosiloxane can have four or more alkenyl groups per molecule. The alkenyl groups in the Q-branched alkenyl-functional polyorganosiloxane can be all terminal or a combination of terminal and pendant, and desirably, four of the alkenyl groups are at terminal positions. Desirably, the Q-branched alkenyl-functional polyorganosiloxane is a Q-branched vinyl-functional polyorganosiloxane. The Q-branched alkenyl-functional polyorganosiloxane may comprise at least one unit of formula (SiO_{4/2}) bonded to three or more polydiorganosiloxane chains of formula (R^{b}₂SiO_{2/2})_{z}, where R^{b} is as defined in formula (I) below, each subscript z is independently 15 to 150. The Q-branched polyorganosiloxane may comprise 1 to 10, 1 to 8, or 1 to 2 units of formula (SiO_{4/2}). "Terminal" groups are on end siloxane groups of a molecule. "End" siloxane groups are attached to only one other siloxane group. "Pendant" groups are on interior siloxane group - siloxane groups bound to at least two other siloxane groups - of the molecule. "Siloxane group" is a group containing SiO that is bound to another Si through the oxygen of the SiO.

The Q-branched alkenyl-functional polyorganosiloxane has a viscosity in a range of 25 to 2000 mPa*s. The Q-branched alkenyl-functional polyorganosiloxane may be a combination of two or more polyorganosiloxanes that may differ in one or more properties selected from molecular weight, structure, siloxane units and sequence. When the Q-branched polyorganosiloxane is a combination of more than one Q-branched polyorganosiloxane then the viscosity is the combined viscosity of Q-branched polyorganosiloxanes. The viscosity of the Q-branched alkenyl-functional polyorganosiloxane is 25 mPa*s or more, and can be 30 mPa*s or more, 40 mPa*s or more, 50 mPa*s or more, 60 mPa*s or more, 70 mPa*s or more, 75 mPa*s or more, 78 mPa*s or more, 80 mPa*s or more, 100 mPa*s or more, 125 mPa*s or more, 150 mPa*s or more, 175 mPa*s or more, even 200 mPa*s or more, while at the same time is 2000 mPa*s or less, and can be 1500 mPa*s or less, 1000 mPa*s or less, 500 mPa*s or less, 400 mPa*s or less, 300 mPa*s or less, 200 mPa*s or less, 150 mPa*s or less, 100 mPa*s or less, 90 mPa*s or less, even 80 mPa*s or less, and desirably, 100 to 600 mPa*s, 150 to 500 mPa*s , or 200 to 400 mPa*s, or 300 to 400 mPa*s, as determined according to ASTM D445-21 using a glass capillary Cannon-Fenske type viscometer at 25 °C.

The Q-branched alkenyl-functional polyorganosiloxane may have an alkenyl content of 0.1 wt% to 5.0 wt%, and can be 0.1 wt% or more, 0.5 wt% or more, 0.7 wt% or more, 0.9 wt% or more, even 1.2 wt% or more while at the same time is generally 5.0 wt% or less, 2.0 wt% or less, 1.5 wt% or less, 1.2 wt% or less, 1.0 wt% or less, 0.8 wt% or less, or even 0.6 wt% or less. The alkenyl content refers to the weight percentages of alkenyl groups relative to the molecular weight of the Q-branched polyorganosiloxane. When alkenyl groups in the Q-branched polyorganosiloxane are vinyl groups, the alkenyl content described above is the vinyl content. Vinyl content herein refers to the weight percentages of vinyl groups relative to the molecular weight of the Q-branched polyorganosiloxane.

Desirably, the Q-branched alkenyl-functional polyorganosiloxane has chemical formula (I): 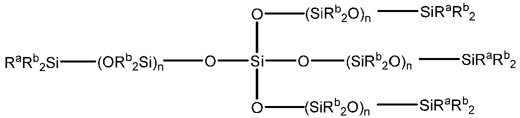 where each R^{a} is independently an alkenyl group, each R^{b} is independently a monovalent hydrocarbon group free of aliphatic unsaturation, n is an integer from 15 to 150 representing the average number of the chain length of different branches of the polyorganosiloxane. In formula (I), n can be 15 or more, and can be 30 or more, 40 or more, 50 or more, 60 or more, 70 or more, 80 or more, even 90 or more while at the same time is generally 150 or less, and can be 120 or less, 100 or less, 85 or less, 75 or less, 65 or less, 55 or less, 45 or less, 35 or less, or even 25 or less, and desirably, n is from 35 to 85.

The alkenyl group for R^{a} is as described above. Particularly suitable alkenyl groups for R^{a} are exemplified by vinyl, allyl, butenyl, and hexenyl. Each R^{a} may be same or different. Desirably, each R^{a} is selected from vinyl or hexenyl. More desirably, each R^{a} is a vinyl group.

The monovalent hydrocarbon group for R^{b} is exemplified by an alkyl group of 1 to 6 carbon atoms or an aryl group of 6 to 10 carbon atoms. Suitable alkyl groups for R^{b} may include, for example, methyl, ethyl, propyl (e.g., iso-propyl and/or n-propyl), butyl (e.g., isobutyl, n-butyl, tert-butyl, and/or sec-butyl), pentyl (e.g., isopentyl, neopentyl, and/or tert-pentyl), hexyl, as well as branched saturated hydrocarbon groups of 6 carbon atoms. Suitable aryl groups for R^{b} are exemplified by phenyl, tolyl, xylyl, naphthyl, benzyl, and dimethyl phenyl. Each R^{b} may be the same or different. Each R^{b} can be an alkyl group. Desirably, each R^{b} is independently methyl, ethyl, or propyl, and more desirably, each R^{b} is methyl.

The Q-branched alkenyl-functional polyorganosiloxane may be one Q-branched polyorganosiloxane or a combination of two or more Q-branched polyorganosiloxanes of formula (I) that may differ in one or more properties selected from molecular weight, structure, siloxane units and sequence. Suitable Q-branched polyorganosiloxanes may include those disclosed in U.S. Patent 6,806,339. Particularly, the Q-branched alkenyl-functional polyorganosiloxane may include one or more Q-branched dimethylvinylsiloxy-terminated polydimethylsiloxanes, and desirably, having viscosities of 200 to 400 mPa*s. For example, the Q-branched polyorganosiloxane can be one or a combination of more than one Q-branched polyorganosiloxane selected from a group consisting of: (A-i) a Q-branched dimethylvinylsiloxy-terminated polydimethylsiloxane having a viscosity of 240 mPa*s and a vinyl content of 0.9 wt%, (A-ii) a Q-branched dimethylvinylsiloxy-terminated polydimethylsiloxane having a viscosity of 300 mPa*s and a vinyl content of 0.72 wt%, and (A-iii) a Q-branched dimethylvinylsiloxy-terminated polymethylvinylsiloxane having a viscosity of 400 mPa*s and a vinyl content of 0.6 wt%. Vinyl content of the Q-branched polyorganosiloxane is as defined above.

The Q-branched alkenyl-functional polyorganosiloxane is present at a concentration of 3.0 wt% to 10 wt%, and can be 3.0 wt% or more, 3.5 wt% or more, 4.0 wt% or more, 4.5 wt% or more, 5.0 wt% or more, greater than 5 wt%, 6 wt% or more, 7 wt% or more, even 7.2 wt% or more while at the same time is generally 10.0 wt% or less, and can be 9.0 wt% or less, 8.5 wt% or less, 8.0 wt% or less, 7.5 wt% or less, 6.5 wt% or less, or even 5.5 wt% or less, and desirably, 4 wt% to 4.5 wt% or 7.0 wt% to 7.5 wt%, based on the weight of the curable thermally conductive composition.

The method of making the curable thermally conductive composition may further comprise or be free of adding component (A') an additional alkenyl-functional polyorganosiloxane that other than the Q-branched alkenyl-functional polyorganosiloxane above. When present, the additional alkenyl-functional polyorganosiloxane (A') may be added together with the Q-branched polyorganosiloxane above component (A) or added into the admixture obtained by the step (I) of the method. Such additional alkenyl-functional polyorganosiloxane (A') can be a linear alkenyl-functional polyorganosiloxane having an average chemical structure (II):

R^{b}_{(3-c)}R^{a}_{c}SiO-(R^{a}R^{b}SiO)ₐ-(R^{b}₂SiO)_{b}-SiR^{a}_{d}R^{b}_{(3-d)} (II)

where R^{a} and R^{b} independently in each occurrence is as described for R^{a} and R^{b} in formula (I) above, subscript a ≥ 0, subscript b > 0, subscript c is zero or 1, subscript d is zero or 1, (a+b) is 20 to 350, and (a+c+d) ≥2. The subscript a can be in a range of 0 to 5. The subscript b can be in a range of 30 to 150. Desirably, each R^{b} is methyl. Each R^{a} can be vinyl. Desirably, subscript a is zero, subscript c is 1, and subscript d is 1.

The concentration of the additional alkenyl-functional polyorganosiloxane (A') may be zero to less than 1 wt%, and can be zero or more, 0.9 wt% or less, 0.8 wt% or less, 0.7 wt% or less, 0.6 wt% or less, 0.5 wt% or less, 0.4 wt% or less, 0.3 wt% or less, 0.2 wt% or less, 0.1 wt% or less, 0.5 wt% or less, even 0.01 wt% or less, and desirably, zero to less than 0.1 wt%, based on the weight of the curable thermally conductive composition. Desirably, the curable thermally conductive composition is free of the additional alkenyl-functional polyorganosiloxane (A').

Component (B1) is a silyl-hydride (SiH) functional polysiloxane crosslinker (also referred to as "SiH crosslinker (B1)"). The SiH functional polysiloxane crosslinker contains at least two silyl-hydride groups (i.e., containing at least two silicon-bonded hydrogen atoms), or even 3 or more, per molecule. The SiH groups can be pendant, terminal or a combination of both pendant and terminal. The SiH functional polysiloxane crosslinker can have an average chemical structure (III):

R^{bb}₍₃₋ₕ₎HₕSiO-(HR^{bb}SiO)ₑ-(R^{bb}₂SiO)_{f}-SiH_{h'}R^{bb}_{(3-h')} (III)

where R^{bb} is independently in each occurrence selected from an alkyl group having from 1 to 6 carbon atoms and phenyl; subscripts h and h' each are independently in each occurrence selected from a value in a range of zero to 3 provided that the combination of e, h, and h' is at least 2; subscript e is zero to 30; and subscript f is 5 to 200.

The R^{bb} group can have one carbon or more, 2 carbons or more, 3 carbons or more, 4 carbons or more, even 5 carbons or more while at the same time 6 carbons or fewer, 5 carbons or fewer, 4 carbons or fewer, 3 carbons or fewer, even 2 carbons or fewer. Desirably, the R^{bb} group is independently in each occurrence selected from methyl and phenyl;
H is a hydrogen atom;
Subscripts h and h' refer to the average number of terminal hydrogen atoms on either end and each are independently in each occurrence selected from a value in a range of zero to 3 provided that the combination of e, h, and h' is at least 2. Desirably, h and h' are independently in each occurrence zero or more, one or more, even 2 or more while at the same time 3 or less, 2 or less, even one or less. More desirably, h and h' have the same value. Most desirably, h and h' are both zero;
Subscript e is the average number of (HR^{bb}SiO) groups per molecule. If h and h' are both zero then e is in a range of 2 to 30. If h and h' are both non-zero then subscript e can be zero to 30 provided the combination of e, h and h' is 2 or more. Desirably, subscript e is 1 or more, and can be two or more and can be 3 or more, 4 or more, 5 or more, 6 or more, 7 or more, 8 or more, even 9 or more and at the same time typically is 30 or less, and can be 25 or less, 20 or less, 15 or less, 10 or less, 9 or less, 8 or less, 7 or less, 6 or less, 5 or less, 4 or less, 3 or less, even 2 or less;
Subscript f is the average number of (R^{bb}₂SiO) groups per molecule. Generally, subscript f is 5 or more, 10 or more, 20 or more, 25 or more, 30 or more, 40 or more, 50 or more, and can be 75 or more, 100 or more, 125 or more, 150 or more, 175 or more, even 190 or more while at the same time is typically 200 or less, 175 or less, 150 or less, 125 or less, 100 or less, 75 or less, 50 or less, 40 or less, 30 or less, 25 or less, or even 20 or less.

The SiH functional polysiloxane crosslinker may have a silicon-bonded hydrogen atom (H) ("SiH") content (i.e., SiH content) of 0.1 wt% to 1.0 wt%, and can be 0.1 wt% or more, 0.11 wt% or more, 0.15 wt% or more, 0.2 wt% or more, 0.25 wt% or more, 0.30 wt% or more, even 0.35 wt% or more while at the same time is generally 1.0 wt% or less, and can be 0.9 wt% or less, 0.8 wt% or less, 0.7 wt% or less, 0.6 wt% or less, 0.5 wt% or less, 0.4 wt% or less, even 0.36 wt% or less, and desirably, 0.1 wt% to 0.8 wt%. SiH content refers to weight percentages of the silicon bonded hydrogen atoms relative to the molecular weight of the SiH functional polysiloxane crosslinker and can be determined using Fourier Transfer Infra-Red (FTIR) spectroscopy.

Suitable SiH functional polysiloxane crosslinkers may include, for example, trimethylsiloxy-terminated poly(dimethylsiloxane/methylhydrogensiloxane), trimethylsiloxy-terminated polymethylhydrogensiloxane, hydrogen-terminated polydimethylsiloxane, hydrogen-terminated poly(dimethylsiloxane/methylhydrogensiloxane), or mixtures thereof. The crosslinker may be a combination of two or more crosslinkers that may differ in one or more properties selected from molecular weight, structure, siloxane units and sequence. Specific examples of SiH crosslinkers include those having average chemical structure of Me₃SiO(Me₂SiO)₇(MeHSiO)₃SiMe₃, Me₃SiO(Me₂SiO)₁₀₈(MeHSiO)₁₀SiMe₃, Me₃SiO(Me₂SiO)₂₂(MeHSiO)₂SiMe₃, or HMe₂SiO(Me₂SiO)₂₅(MeHSiO)₁SiMe₂H; or mixtures thereof. Suitable commercially available SiH crosslinkers include those available under the names HMS-071, HMS-501 and DMS-H11 all available from Gelest. Desirably, the crosslinker can be one or a combination of both polymers selected from a group consisting of: (B-i) trimethyl terminated dimethyl-co-hydrogen methyl polysiloxane with a viscosity of 10-15 mPa*s and a SiH content of 0.36 wt%; and (B-ii) hydride terminated polydimethylsiloxane having a viscosity in a range of 7-10 mPa*s and a SiH content of 0.16 wt%.

To ensure desirable dispensability and reduced oil bleeding properties of the curable thermally conductive composition, the SiH crosslinker (B1) used in the step (I) is in an amount to provide a molar ratio of silicon-bonded hydrogen atoms from the SiH crosslinker (B1) to alkenyl groups (desirably, vinyl groups) in the Q-branched alkenyl-functional polyorganosiloxane (A), also as "SiH_{B1}/Vi ratio", in a range of 0.2 to 0.35, and can be 0.2 or more, 0.21 or higher, 0.22 or higher, 0.23 or higher, 0.24 or higher, even 0.25 or higher while at the same time is 0.35 or less, and can be 0.34 or less, 0.33 or less, 0.32 or less, 0.31 or less, 0.30 or less, 0.29 or less, or even 0.28 or less, and desirably, 0.22 to 0.28. If the SiH_{B1}/Vi ratio is too low, then the resulting curable composition tends to provide undesirable oil bleeding property. If the SiH_{B1}/Vi ratio is too high then the resulting curable composition tends to provide an extrusion rate too low to be dispensable.

Component (C) comprises one or more thermally conductive fillers. The thermally conductive filler (C) may include both an electrically conductive filler and an electrically insulating filler. Component (C) comprises a metallic filler, an inorganic filler, a meltable filler, or a combination thereof. Metallic fillers include particles of metals exemplified by aluminum, copper, gold, nickel, silver, and combinations thereof. Inorganic fillers are exemplified by aluminum trihydrate; magnesium hydroxide; diamond; metal oxides such as aluminum oxide, beryllium oxide, magnesium oxide, and zinc oxide; nitrides such as aluminum nitride and boron nitride; carbides such as silicon carbide and tungsten carbide; and combinations thereof. Meltable fillers may comprise Bi, Ga, In, Sn, and an alloy thereof, and may optionally further comprise Ag, Au, Cd, Cu, Pb, Sb, Zn, and a combination thereof.

The shape of the thermally conductive filler particles can be spherical or irregular. Component (C) may be a single thermally conductive filler or a combination of two or more thermally conductive fillers that differ in at least one property such as particle shape, average particle size, particle size distribution, and type of filler. The average particle size of the thermally conductive filler will depend on various factors including the type of thermally conductive filler selected for component (C) and the exact amount added to the curable composition, as well as the bondline thickness of the devices in which the cured product of the composition will be used (i.e., the largest particle size should be smaller than the bondline thickness). The thermally conductive filler may have a D50 particle size ranging from 0.1 micrometer (µm) to 120 µm, 0.1 µm to 100 µm, 0.1 µm to 50 µm, 0.1 µm to 35 µm, 0.1 µm to 10 µm, or 0.1 µm to 5 µm.

The amount of component (C) depends on various factors including TC properties of the fillers selected for component (C). The method of the present invention enables the incorporation of a high amount of component (C), i.e., ≥ 90 wt% based on the curable thermally conductive composition weight, typically added in the step (I) of the method, thus achieving reduced oil bleeding without compromising ER and TC, as compared to conventional methods in the art. The total concentration of component (C) may be 90 wt% or more, and can be 90.5% or more, 90.8 wt% or more, 91 wt% or more, 91.2 wt% or more, 95 wt% or more, 95.4% or more, even 95.5 wt% or more while at the same time is typically 96.5 wt% or less, and can be 96 wt% or less, 95.5 wt% or less, 95.2 wt% or less, 95 wt% or less, 94.5 wt% or less, or even 94 wt% or less, and desirably, 91 wt% to 94 wt%, based on the weight of the curable thermally conductive composition.

Desirably, component (C) comprises, or can consist of, a combination of at least three different thermally conductive fillers, i.e., (c1), (c2), and (c3), described below.

The first thermally conductive filler (c1) has a D50 particle size of 10 µm to 120 µm, and can have a D50 of 10 µm or more, 20 µm or more, 25 µm or more, 30 µm or more, 40 µm or more, 50 µm or more, even 70 µm or more while at the same time has a D50 particle size of 120 µm or less, and can have a D50 of 100 µm or less, 80 µm or less, 60 µm or less, 50 µm or less, 45 µm or less, even 35 µm or less. The first thermally conductive filler (c1) may be selected from aluminum oxide, aluminum nitride, magnesium oxide, or combinations thereof. Desirably, the first thermally conductive filler particles (c1) are spherical shape. The concentration of (c1) may be 30 wt% to 65 wt%, and can be 30 wt% or more, 35 wt% or more, 40 wt% or more, 45 wt% or more, 50 wt% or more, 52 wt% or more, or even 52.4 wt% or more while at the same time is generally 65 wt% or less, and can be 60 wt% or less, 58 wt% or less, 54 wt% or less, 53.5 wt% or less, 53 wt% or less, even 52.5 wt% or less, based on the weight of the curable composition. Desirably, the first thermally conductive filler is 40 wt% to 60 wt% of aluminum oxide particles having a D50 of 20 to 50 µm, based on the weight of the curable composition.

The second thermally conductive filler (c2) has a D50 particle size of 1 µm to less than 10 µm, and can have a D50 of 1 µm or more, 1.5 µm or more, even 2 µm or more while at the same time have a D50 particle size of less than 10 µm, and can have a D50 of 9 µm or less, 8 µm or less, 6 µm or less, 5 µm or less, 3 µm or less, even less than 3 µm. The concentration of (c2) is 20 wt% to 40 wt%, and can be 20 wt% or more, 22 wt% or more, 25 wt% or more, 26 wt% or more, even 27 wt% or more while at the same time is 40 wt% or less, and can be 38 wt% or less, 36 wt% or less, 35 wt% or less, 34 wt% or less, 33 wt% or less, 32 wt% or less, 31 wt% or less, 30 wt% or less, even 27 wt% or less, based on the weight of the curable composition. The second thermally conductive filler may be selected from aluminum oxide, aluminum nitride, or mixtures thereof, and desirably, crushed or irregular aluminum oxide. More desirably, the second thermally conductive filler is 20 to 30 wt% of irregular aluminum oxide particles having a D50 of 1 to 5 µm.

The third thermally conductive filler (c3) has a D50 particle size of 0.1 µm to less than 1 µm, and can have a D50 of 0.1 µm or more, 0.2 µm or more, 0.3 µm or more, 0.5 µm or more, 0.7 µm or more, 0.8 µm or more, even 0.9 µm or more while at the same time has a D50 particle size less than 1 µm, and can have a D50 of 0.8 µm or less, 0.5 µm or less, less than 0.5 µm or less, or even 0.2 µm or less. The concentration of the third thermally conductive filler (c3) is 8 wt% or more, and can be 10 wt% or more, 12 wt% or more, even 12.6 wt% or more, while at the same time is 20 wt% or less, and can be 19 wt% or less, 18 wt% or less, 17 wt% or less, 15 wt% or less, 13 wt% or less, or even 12.6 wt% or less, based on the weight of the curable composition. The third thermally conductive filler may be selected from zinc oxide, aluminum oxide, or mixtures thereof, and desirably, the third thermally conductive filler is irregular zinc oxide. More desirably, the third thermally conductive filler is selected from 10 to 15 wt% of irregular zinc oxide particles having a D50 of 0.1 to 0.5 µm.

The thermally conductive filler (C) can comprise fillers in addition to these three thermally conductive fillers described above or be free of thermally conductive fillers other than these three (i.e., the thermally conductive filler consists of (c1), (c2), and (c3)). The particles described above each independently can have any shape such as spherical, irregular, crushed or platelet.

Desirably, the thermally conductive filler (C) comprises or consists of:
(c1) from 40 to 60 wt% of aluminum oxide particles, desirably, spherical aluminum oxide particles, having a D50 of 20 to 50 µm;
(c2) from 25 to 40 wt% of aluminum oxide particles, desirably, crushed aluminum oxide particles having a D50 of 1 to 5 µm; and
(c3) from 10 to 20 wt% of zinc oxide particles, desirably, crushed zinc oxide, having a D50 of 0.1 to 0.5 µm.

Component (D) is one or a combination of more than one filler treating agent. The filler treating agent (D) may comprise, or consists of, one or any combination of more than one trialkoxysilyl diorganopolysiloxane, which is a diorganopolysiloxane that contains a -Si(OR^{e})₃ group, where R^{e} is independently in each occurrence as described for R^{e} herein below in (IV). Desirably, the trialkoxysilyl diorganopolysiloxane is a mono-trialkoxysiloxy terminated diorganopolysiloxane. Suitable monotrialkoxysiloxy-terminated diorganopolysiloxanes include those having the average chemical structure (IV):

R^{c}₃SiO[R^{d}₂SiO]_{g}Si(OR^{e})₃ (IV)

where R^{c}, R^{d}, and R^{e} are each independently in each occurrence selected from hydrocarbyls having from 1 to 10 carbon atoms such as alkyl and aryl groups, for example, having 1 or more, 2 or more, 3 or more, 4 or more, 5 or more, 6 or more, 7 or more, even 8 or more carbon atoms while at the same time typically having 10 or fewer, 8 or fewer, 6 or fewer, 4 or fewer, even 2 or fewer carbon atoms; and subscript g typically has a value of 20 or more, 25 or more, 30 or more, 40 or more, 50 or more, 60 or more, 70 or more, 80 or more, 90 or more, 100 or more, or even 110 or more, while at the same time typically has a value of 150 or less, and can be 125 or less, 120 or less, 110 or less, 100 or less, 90 or less, 80 or less, 70 or less, 60 or less, 50 or less, 40 or less, or even 30 or less. Desirably, subscript g has a value in a range of 25 to 110. Each R^{c}, R^{d}, and R^{e} can be the same or different. Suitable alkyl groups for R^{c}, R^{d}, and R^{e} are exemplified by methyl, ethyl, propyl (e.g., iso-propyl and/or n-propyl), butyl (e.g., isobutyl, n-butyl, tert-butyl, and/or sec-butyl), pentyl (e.g., isopentyl, neopentyl, and/or tert-pentyl), hexyl, as well as branched saturated hydrocarbon groups of 6 carbon atoms. R^{c}, R^{d}, and R^{e} each can be independently an alkyl group such as methyl, ethyl, and propyl. Desirably, each R^{c}, R^{d}, and R^{e} is methyl. Suitable aryl groups for R^{c}, R^{d}, and R^{e} may include phenyl and dimethyl phenyl. A particularly desirable monotrialkoxysiloxy-terminated diorganopolysiloxane is a monotrimethoxysiloxy and trimethylsiloxy terminated polydimethylsiloxane such as those having the average chemical formula (CH₃)₃SiO[(CH₃)₂SiO]₃₀Si(OCH₃)₃. Suitable mono-trialkoxysiloxy terminated dimethylpolysiloxanes can be synthesized according to the teachings in US2006/0100336.

The filler treating agent (D) may comprise or be free of one or a combination of more than one alkyl trialkoxysilane. Suitable alkyl trialkoxysilanes include those having the chemical formula (V):

R^{f}Si(OR^{g})₃ (V)

where R^{f} is independently in each occurrence an alkyl group having 6 or more, 7 or more, 8 or more, 9 or more, or even 10 or more carbon atoms, while at the same time typically an alkyl having 20 or less, 18 or less, 16 or less, 14 or less, 12 or less, or even 10 or less carbon atoms; and R^{g} is independently in each occurrence an alkyl having 1 or more, 2 or more, 3 or more, 4 or more, or even 5 or more carbon atoms, while at the same time generally having 6 or less, 5 or less, 4 or less, 3 or less, or even 2 or less carbon atoms. Desirably, R^{f} is independently in each occurrence an alkyl group having from 6 to 20 carbon atoms. R^{g} is desirably methyl so as to form methoxyl groups attached to the silicon atom. A particularly desirable alkyl trialkoxysilane is n-decyltrimethoxysilane, n-Octyltrimethoxysilane, or a mixture thereof. Suitable alkyl trialkoxysilanes include n-decyltrimethoxysilane available from The Dow Chemical Company as DOWSIL^{™} Z-6210 Silane or under the name SID2670.0 from Gelest.

The filler treating agent (D) useful in the present invention may be present at a total concentration of 0.1 wt% to 2.0 wt%, and can be 0.1 wt% or more, 0.2 wt% or more, 0.3 wt% or more, 0.4 wt% or more, 0.5 wt% or more, 0.6 wt% or more, 0.7 wt% or more, 0.8 wt% or more, 0.9 wt% or more, 1.0 wt% or more, 1.2 or more, 1.3 wt% or more, even 1.4 wt% or more while at the same time is typically 2.0 wt% or less, and can be 1.8 wt% or less, 1.6 wt% or less, 1.5 wt% or less, or less, 1.4 wt% or less, 1.3 wt% or less, or even 1.2 wt% or less, based on the weight of the curable thermally conductive composition. Desirably, the trialkoxysilyl diorganopolysiloxane is present at a concentration of zero to 2.0 wt%, and can be greater than zero, 0.3 wt% or more, 0.4 wt% or more, 0.5 wt% or more, 0.6 wt% or more, 0.7 wt% or more, 0.8 wt% or more, 0.9 wt% or more, 1.0 wt% or more, 1.1 wt% or more, 1.2 wt% or more, 1.3 wt% or more, even 1.4 wt% or more while at the same time is typically present at a concentration of 2.0 wt% or less, and can be 1.8 wt% or less, 1.7 wt% or less, 1.6 wt% or less, 1.5 wt% or less, or even 1.4 wt% or less, based on the weight of the curable thermally conductive composition. At the same time, or alternatively, the alkyltrialkoxysilane may be present at a concentration of zero or more, and can be 0.01 wt% or more, 0.05 wt% or more, 0.1 wt% or more, 0.2 wt% or more, 0.3 wt% or more, or even 0.4 wt% or more while at the same time is typically present at a concentration of 0.5 wt% or less, and can be 0.4 wt% or less, 0.3 wt% or less, or even 0.2 wt% or less, based on the weight of the curable thermally conductive composition. The filler treating agent (D) can be a mixture of the trialkoxysilyl diorganopolysiloxane such as a monotrimethoxysiloxy and trimethylsiloxy terminated polydimethylsiloxane and the alkyl trialkoxysilane. For example, the curable thermally conductive composition can comprise a monotrimethoxysiloxy and trimethylsiloxy terminated polydimethylsiloxane such as (CH₃)₃SiO[(CH₃)₂SiO]₃₀Si(OCH₃)₃ or its combination with n-decyltrimethoxysilane. Desirably, the curable thermally conductive composition comprises, based on the weight of the curable thermally conductive composition, from 0.1 to 0.3 wt% of n-decyltrimethoxysilane and from 0.5 to 1.5 wt% of the monotrimethoxysiloxy and trimethylsiloxy terminated polydimethylsiloxane.

Component (E) is one or more platinum-based hydrosilylation reaction catalyst. Such hydrosilylation reaction catalyst may include compounds and complexes such as platinum (0)-1,3-divinyl-1,1,3,3-tetramethyldisiloxane (Karstedt's catalyst), H₂PtCl₆, di-µ.-carbonyl di-.π.-cyclopentadienyldinickel, platinum-carbonyl complexes, platinum-divinyltetramethyldisiloxane complexes, platinum cyclovinylmethylsiloxane complexes, platinum acetylacetonate (acac), platinum black, platinum compounds such as chloroplatinic acid, chloroplatinic acid hexahydrate, a reaction product of chloroplatinic acid and a monohydric alcohol, platinum bis(ethylacetoacetate), platinum bis(acetylacetonate), platinum dichloride, and complexes of the platinum compounds with olefins or low molecular weight organopolysiloxanes or platinum compounds microencapsulated in a matrix or core-shell type structure. The hydrosilylation reaction catalyst can be part of a solution that includes complexes of platinum with low molecular weight organopolysiloxanes that include 1,3-diethenyl-1,1,3,3-tetramethyldisiloxane complexes with platinum. These complexes may be microencapsulated in a resin matrix (typically, in a phenyl resin) or non-encapsulated. The resin matrix for microencapsulating the complexes can be a phenyl resin, an acrylate polymer, a polycarbonate, or other resin matrix which has a melting point less than 150 °C to release Pt during heat curing. Exemplary hydrosilylation reaction catalysts are described in U.S. Patents 3,159,601 and 3,220,972, and encapsulated platinum catalysts described in WO2014017671A1. The catalyst can be 1,3-diethenyl-1,1,3,3-tetramethyldisiloxane complex with platinum. Platinum-based hydrosilylation reaction catalysts are commercially available, for example, SYL-OFF^{™} 4000 Catalyst, SYL-OFF 4500 Catalyst, and SYL-OFF 2700 Catalyst are available from Dow Silicones Corporation (SYL-OFF is a trademark of Dow Silicones Corporation). In some embodiments, two different catalysts (e.g., E1 and E2) that activate at different temperatures can be added. The two different catalysts may be (E1) 1,3-diethenyl-1,1,3,3-tetramethyldisiloxane complex with platinum, and (E2) an encapsulated platinum catalyst, such as 1,3-diethenyl-1,1,3,3-tetramethyldisiloxane complex with platinum which is encapsulated in dimethyl siloxane with phenyl silsesquioxane.

The amount of the platinum-based hydrosilylation reaction catalyst (E) is sufficient to provide 0.5 part per million (ppm) to 300 ppm, and can be 0.5 ppm or more, 5 ppm or more, 10 ppm or more, 20 ppm or more, even 30 ppm or more while at the same time is generally 300 ppm or less, and can be 200 ppm or less, 130 ppm or less, 100 ppm or less, or even 50 ppm or less, of the platinum, based on the weight of the curable thermally conductive composition. Alternatively, the amount of the platinum-based hydrosilylation reaction catalyst may be 0.01 wt% to 0.6 wt%, based on the weight of the curable thermally conductive composition. The platinum-based hydrosilylation reaction catalyst (E) can be added in the step (I), and optionally, also added after step (I).

In the step (II) of the method of the present invention, the admixture obtain from the step (I) can undergo a crosslinking reaction ("curing") under heating, thereby forming a pre-cured composite. The crosslinking reaction includes a hydrosilylation reaction between the Q-branched alkenyl-functional polyorganosiloxane and the SiH crosslinker (B1). The step (II) of the method (i.e., the pre-curing step) can be conducted by heating at temperatures greater than 50 °C to 150 °C, and can be 60 °C or higher, 70 °C or higher, 80 °C or higher, 90 °C or higher, even 100 °C or higher while at the same time is generally 150 °C or lower, and can be 140 °C or lower, 130 °C or lower, 120 °C or lower, 110 °C or lower, 100 °C or lower, or even 90 °C or lower. Time for the pre-curing step may vary depending on temperatures, for example, 30 to 120 minutes. Alternatively, the pre-curing step can be conducted at 90 °C to 120 °C for 30 to 60 minutes or at 60 °C to 90 °C for 60 to 120 minutes.

The step (III) of the method of making the curable thermally conductive composition includes admixing the obtained pre-cured composite with component (B2) a silyl-hydride functional polysiloxane crosslinker that contains at least two silyl-hydride groups per molecule (hereinafter referred to as "SiH crosslinker (B2)"). The admixing the pre-cured composite with the SiH crosslinker (B2) at step (III) can be conducted at temperatures lower than 30 °C, and desirably, at room temperature (25 °C). The SiH crosslinker (B2) is as described for the SiH crosslinker (B1) for component (B1) above. The SiH crosslinker (B2) and SiH crosslinker (B1) each independently can be the same or different. The SiH crosslinker (B2) is used in an amount to provide a mole ratio of total silicon-bonded hydrogen atoms from the SiH crosslinkers (B1) and (B2) to alkenyl groups (desirably, vinyl groups) in the Q-branched alkenyl-functional polyorganosiloxane (A) (also as "(SiH_{B1}+SiH_{B2})/Vi ratio") of greater than 0.45, and can be 0.46 or higher, 0.47 or higher, 0.48 or higher, 0.5 or higher, 0.6 or higher, 0.7 or higher, 0.8 or higher, even 0.9 or higher. The (SiH_{B1}+SiH_{B2})/Vi ratio may be generally 1.5 or less, and can be 1.4 or less, 1.2 or less, 1.0 or less, 0.9 or less, 0.8 or less, 0.7 or less, 0.6 or less, 0.58 or less, or even 0.54 or less, and desirably, from 0.5 to 0.6.

The method of making the curable thermally conductive composition of the present invention may comprise the addition of optional components including component (F) an inhibitor, component (E') an additional platinum-based hydrosilylation reaction catalyst, other optional components described below, or mixtures thereof. One or more than one of these optional components can be added after obtaining the pre-cured composite from step (II), and before, during, and/or after addition of the SiH crosslinker (B2). The method may comprise addition of the additional platinum-based hydrosilylation reaction catalyst (E') to catalyze the hydrosilylation reaction of SiH crosslinker (B2). The additional platinum-based hydrosilylation reaction catalyst (E') includes those described for component (E) above and can be the same or different from the platinum-based hydrosilylation reaction catalyst (E) added in step (I) above. Desirably, the method of the present application comprises addition of component (F). Component F and component (B2) (i.e., SiH crosslinker (B2)) can be added together or component (F) can be added before or after addition of component (B2). Component (F) comprises one or a combination of more than one hydrosilylation reaction inhibitor (also as "inhibitor"). Inhibitors can serve to stabilize the curable thermally conductive composition from premature curing and provide storage stability to the composition. Examples of suitable inhibitors include any one or any combination of more than one of acetylene-type compounds such as 2-methyl-3-butyn-2-ol; 3-methyl-l-butyn-3-ol; 3,5-dimethyl-l-hexyn-3-ol; 2-phenyl-3-butyn-2-ol;3-phenyl-l-butyn-3-ol; 1-ethynyl-1-cyclohexanol; 1,1-dimethyl-2-propynyl)oxy)trimethylsilane; and methyl(tris(l,l-dimethyl-2-propynyloxy))silane; ene-yne compounds such as 3-methyl-3-penten-l-yne and 3,5-dimethyl-3-hexen-l-yne; triazols such as benzotriazole; hydrazine-based compounds; phosphines-based compounds; mercaptan-based compounds; cycloalkenylsiloxanes including methylvinylcyclosiloxanes such as l,3,5,7-tetramethyl-1,3,5,7-tetravinyl cyclotetrasiloxane and l,3,5,7-tetramethyl-l,3,5,7-tetrahexenyl cyclotetrasiloxane.

The concentration of the inhibitor (F) is zero or more, and can be 0.001 wt% or more, 0.002 wt% or more, even 0.003 wt% or more while at the same time is typically 0.5 wt% or less, and can be 0.3 wt% or less, 0.1 wt% or less, 0.05 wt% or less, 0.01 wt% or less, 0.005 wt% or less, 0.004 wt% or less, even 0.003 wt% or less, based on the weight of the curable thermally conductive composition.

Other optional components may include any one or any combination of more than one of the following components: heat stabilizers and/or pigments (such as copper phthalocyanine powder), thixotropic agents, fumed silica (desirably, surface treated), and spacer additives (such as glass beads). The total concentration for these additional components can be in a range of from zero to 1 wt%, and can be zero or more, 0.1 wt% or more, 0.2 wt% or more, 0.3 wt% or more, 0.4 wt% or more, even 0.5 wt% or more while at the same time is typically 1 wt% or less, and can be 0.9 wt% or less, 0.8 wt% or less, or even 0.6 wt% or less, based on the weight of the curable thermally conductive composition.

When used, the above optional components each independently may be added in the step (I) and/or step (III), desirably, in step (III), these optional components are included to the composition together with, before, or after addition of, the SiH crosslinker (B2).

The method of making the curable thermally conductive composition may comprise or be absent of a step of adding a solvent. The solvent if present can be less than 0.01 wt%, less than 0.005 wt%, or even zero, based on the weight of the curable thermally conductive composition. Desirably, the curable thermally conductive composition is substantially free of a solvent, i.e., contains no solvent or may contain trace amounts of residual solvents from delivery of starting materials in the composition. The concentration of the solvent can be measured by gas chromatography (GC). If the amount of solvents is too high, voids tend to be generated during curing the curable thermally conductive composition, which gives poor surface appearance or even results in a decreased TC. The solvent can be an organic solvent such as an aliphatic or aromatic hydrocarbon, which is saturated or unsaturated, such as benzene, toluene, xylene, hexane, heptane, octane, iso-paraffin, hydrocarbon compounds of 8 to 18 carbon atoms and at least one aliphatic unsaturation per molecule such as tetradecene; a ketone such as acetone, methyl ethyl ketone, or methyl isobutyl ketone; an ester acetate such as ethyl acetate or isobutyl acetate; an ether such as a glycol ether such as propylene glycol methyl ether, dipropylene glycol methyl ether, and propylene glycol n-butyl ether, diisopropyl ether or 1,4-dioxane; a cyclic or linear siloxane having an average degree of polymerization from 3 to 10 such as hexamethylcyclotrisiloxane, octamethylcyclotetrasiloxane, and/or decamethylcyclopentasiloxane; or mixtures thereof. The curable thermally conductive composition does not require the use of any solvents such as those described above to achieve the desired ER (i.e., good processability) and TC properties above.

The present invention also relates to a curable thermally conductive composition prepared from the method above or comprising an admixture of a pre-cured composite with the SiH crosslinker (B2). The pre-cured composite comprises component (C), component (D), and a hydrosilylation reaction product of components (A), (B1), and (E). All components are as described above. The concentrations of these components in the composition and molar ratios (e.g., SiH_{B1}/Vi ratio and (SiH_{B1}+SiH_{B2})/Vi ratio) are as described in the method above. The curable thermally conductive composition can achieve all of the following properties: (i) an oil bleeding degree of no more than 10% (≤ 10%) after being applied at 25 °C for 5 days; (ii) an oil bleeding degree of no more than 10% (≤ 10%) after aging at 125 °C for 2 days; (iii) an ER of 15 g/min or more; and (iv) a TC of greater than 3.0 W/m*K. The oil bleeding properties are determined according to the test method described in the Oil Bleeding Test. ER herein is determined at a pressure of 0.62 MegaPascals (MPa) and 25 °C with a standard 30 cubic centimeters EFD syringe package (further details provided below under Extrusion Rate Test). The thermally conductive composition can have an ER of 15 g/min or more, and can be 18 g/min or more, or even 20 g/min or more. ER is a useful characteristic as a measure of extrudability, viscosity, dispensability, which, for example, makes the curable thermally conductive composition easily dispensable for applying onto another material such as electronic components or heat sinks. TC is measured using a hot disk according to ISO 22007-2 with cured samples (further details provided below under the Thermal Conductivity Test), which can be greater than 3.0 W/m*K (>3.0 W/m*K), 3.5 W/m*K or more, or even 4.5 W/m*K or more. Having such a high TC (affording an efficient thermal dissipation), low oil bleeding, and by being easily dispensable makes the curable thermally conductive composition particularly useful as a thermally conductive interface material to efficiently transfer heat between two components. Thermally conductive interface materials are typically used to thermally couple heat generating components and heat dissipating components, especially in electronics. The thermally conductive composition can be supplied as one-part form.

The present invention also includes a process for forming a thermally conductive silicone material on an electronic component, the process comprising:
step (i) providing the curable thermally conductive composition prepared by the method described above;
step (ii) applying the curable thermally conductive composition on the electronic component for an electronic device; and
step (iii) curing the curable composition by heat; thereby forming the thermally conductive silicone material (i.e., a cured material).

Desirably, the applying of the curable thermally conductive composition involves dispensing or extruding the curable thermally conductive composition. Due to the above described properties of the curable thermally conductive composition such as excellent dispensability and conformability, the process allows for automated dispensing and assembly (i.e., increased productivity) with minimal stress applied to fill in intricate geometries and diverse gaps, therefore avoiding potential damages to the electronic components.

In step (iii) of the process, the thermally conductive composition can be cured by heat, for example, at temperatures greater than 25 °C, and can be greater than 40 °C, such as from 60 to 150 °C or from 80 to 120 °C. The duration time for curing may vary depending on the temperatures, typically 0.5 to 24 hours. The curable thermally conductive composition can be cured by heating in an oven, or by heat generated by the electronic component. Desirably, when the electronic device is in operation, the heat generated from the electronic component cures the curable thermally conductive composition typically within several hours, thereby forming the cured material. Curing at step (iii) of the process is not conducted under moisture conditions which, however, are required for conventional curing approaches. The conventional curing approaches use moisture in the air to cure a composition and take longer (e.g., 7 days) for the composition to be fully cured, therefore, are not suitable for electronic applications.

Due to the low concentration or absence of the solvent in the curable thermally conductive composition, the process does not involve (that is, is free of) an extra procedure for removal of the solvent, e.g., stripping off or evaporating the solvent. While still affording the resulting composition with desired ER and TC properties as described above, the curable thermally conductive composition enables the process for using the composition without the aid of a solvent and also makes it applicable to dispense (e.g., by extrusion) the composition directly onto components of articles without requiring addition of solvents to the composition before use.

Examples of the electronic components which generate heat during the electronic device is operated include central processing units (CPU), graphics processing units (GPU), memory chips, driver chips and optical modules. The thermally conductive composition can be applied on one or two electronic components which generate heat. The thermally conductive composition can be between and in contact with one electronic component and a heat dissipating component such as a heat sink, or between and in contract with two electronic components of the electronic device, where at least one electronic component generates heat when the electronic device is in operation. Examples of the heat dissipating components include a heat sink, cooling plate/pad, cooling tube, and metal cover. The present invention further includes an electronic article comprising the thermally conductive composition and the electronic component where the thermally conductive composition is applied on. Examples of the electronic devices include optical modules, smartphones, digital cameras, computers, pad devices, servers and base stations for communication.

### EXAMPLES

Some embodiments of the invention will now be described in the following Examples, wherein all percentages (%) are by weight relative to the weight of a composition and all particle sizes of fillers are D50 particle sizes, unless otherwise specified. Table 1 lists the materials for use in the thermally conductive composition of the samples described herein below. Note: "Vi" represents vinyl and "Me" represents methyl. SYL-OFF is a trademark of Dow Coming Corporation.

**Table 1**

| **Component** | **Description** | Source |
|---|---|---|
| Q-branched vinyl polymer A-1 | Q-branched dimethylvinylsiloxy-terminated polydimethylsiloxane of unit formula: [ViMe₂SiO-(SiMe₂O)₆₀]₄Si with a viscosity of 400 mPa*s at 25 °C and a vinyl content of 0.6 wt% | This material can be synthesized according to the teachings in WO2008/084747A2 in paragraph [0063], starting from line 10, page 26 |
| Linear vinyl polymer A-2 | ViMe₂SiO-(Me₂SiO)ₓ-SiMe₂Vi, where subscript x is a value to provide a viscosity of 400 mPa*s at 25 °C and a vinyl content of 0.48 wt% | Available from The Dow Chemical Company |
| Linear vinyl polymer A-3 | ViMe₂SiO-(Me₂SiO)ₓ-SiMe₂Vi, where subscript x is a value to provide a viscosity of 40000 mPa*s at 25 °C and a vinyl content of 0.08 wt% | Available from The Dow Chemical Company |
| SiH crosslinker B1-1 | Me₃SiO-(Me₂SiO)₇-(MeHSiO)₃-SiMe₃ (SiH content = 0.36 wt%) | Available from The Dow Chemical Company |
| SiH crosslinker B1-2 | Me₃SiO-(Me2SiO)₂₂-(MeHSiO)₂-SiMe₃ (SiH content = 0.10 wt%) | Available from The Dow Chemical Company |
| SiH crosslinker B1-3 | HMe₂SiO-(Me₂SiO)₂₅-(MeHSiO)-SiMe₂H (SiH content = 0.15 wt%) | Available from The Dow Chemical Company |
| SiH crosslinker B2-1 | Me₃SiO-(Me₂SiO)₁₀₈-(MeHSiO)₁₀-SiMe₃ (SiH content = 0.11 wt%) | Available from The Dow Chemical Company |
| SiH crosslinker B2-2 | Me₃SiO-(Me₂SiO)₇-(MeHSiO)₃-SiMe₃ (SiH content = 0.36 wt%) | Available from The Dow Chemical Company |
| SiH crosslinker B2-3 | Me₃SiO-(Me₂SiO)₂₂-(MeHSiO)₂-SiMe₃ (SiH content = 0.10 wt%) | Available from The Dow Chemical Company |
| TC filler C-1 | Roundish alumina particles with a D50 of 35 µm | Available from ZRI |
| TC filler C-2 | Irregular alumina particles of a D50 of 2 µm | Available from Sumitomo Chem. |
| TC filler C-3 | Irregular zinc oxide particles with a D50 of 0.12 µm | Available from Zochem |
| Treating agent D-1 | n-Octyltrimethoxysilane | Available from The Dow Chemical Company |
| Treating agent D-2 | Me₃SiO-(Me₂SiO)₃₀-Si(OMe)₃ | This material can be synthesized according to the teachings in US2006/0100336A1. |
| Catalyst E-1 | 1,3-Diethenyl-1,1,3,3 -Tetramethyldisiloxane complex with platinum (Pt) (Pt content = 0.52 wt%) | Available as SYL-OFF^{™} 4000 catalyst from The Dow Chemical Company |
| Catalyst E-2 | 1,3-Diethenyl-1,1,3,3 -Tetramethyldisiloxane Complexes (Platinum) encapsulated in Dimethyl Siloxane with Phenyl Silsesquioxane. This catalyst is a mixture containing 40 wt% of a complex of platinum with 1,3-divinyl-1,1,3,3-tetramethyldisiloxane dispersed in a thermoplastic silicone resin, wherein the resin has 78 mole percent monophenylsiloxane units and 22 mole percent dimethylsiloxane units and the resin has a softening point of 80-90 °C; 55 wt% of a dimethylvinylsiloxy-terminated polydimethylsiloxane having a viscosity of 2 Pa-s at 25 °C and a vinyl content of 0.2 wt%; and 5 wt% of a hexamethyldisilazane-treated fumed silica. The catalyst has a Pt content of 0.16 wt%. | Such microencapsulated hydrosilylation catalysts and methods of preparing them are described in U.S. Pat. No. 4,766,176. |
| Inhibitor F-1 | 0.5 wt% of Methyl(tris(1,1-dimethyl-2-propynyloxy))silane in 99.5 wt% of Q-branched vinyl polymer A-1 | Available from The Dow Chemical Company |
| G-1 | Iron(III) Oxide in Dimethyl Siloxane, Dimethylvinylsiloxy-terminated | Available from The Dow Chemical Company |

| | | |
|---|---|---|
| *"Viscosity" of vinyl polymer was measured by ASTM D445-21 at 25* °*C.* *"Vinyl content" of vinyl polymer refers to wt% of vinyl groups relative to the molecule weight of a vinyl polymer.* *"SiH content" refers to wt% of Hfrom SiH, relative to the molecule weight of the SiH crosslinker.* *"Pt content" refers to wt% of Pt, relative to the molecule weight of the catalyst.* *"TC filler" refers to thermally conductive filler.* | | |

### IE 1-5 Samples

Formulations for IE samples are given in Table 2, with the amount of each component reported in grams (g). Samples were prepared by using SpeedMixer^{™} DAC 400 FVZ from Flack Tek Inc. to mix the components together at room temperature (RT) unless otherwise stated. Silicone matrix components including Vinyl Polymer (A), SiH crosslinker (B1), and Treating agent (D) were weighed into a cup of the SpeedMixer. Then TC filler (C3) was weighed and added into the cup. This mixture was mixed by the SpeedMixer at 1000 revolutions per minute (RPM) for 20 seconds, then 1500 RPM for 20 seconds. Then TC filler (C2) was added and then mixed in the same way. TC filler (C1) was further added under the same mixing condition. The resulting composition in the cup was scraped and mixed again. Pt catalyst (E) comprising Catalyst E-1 and optionally Catalyst E-2 was added and then mixed. The material was then placed into an oven and kept at 70 °C for 60 min ("heating step"). This temperature is below the activation temperature of Catalyst E-2. After that, the contents in the cup were cooled down to RT. Then SiH crosslinker (B2), Inhibitor (F), Pigment (G) were added into the cup and mixed at 1000 RPM for 30 seconds to obtain the curable thermally conductive silicone composition samples.

### CE 1-5 Samples

Formulations for CE samples are given in Table 3 with the amount of each component reported in grams (g). CE 1 sample was prepared according to the same procedure as for preparing IE samples above, except no SiH crosslinker (B2) was used. CE 2, CE 3, and CE 5 samples were prepared according to the same procedure for preparing IE samples.

CE 4 sample was prepared according to the same procedure as IEs above except the heating step was omitted.

The above obtained thermally conductive composition samples were evaluated for ER, TC, oil bleeding, and hardness according to the following test methods:

### Extrusion Rate Test

Determine extrusion rate ("ER") for a sample using Nordson EFD dispensing equipment. Package sample material into a 30 cubic centimeter syringe with a 2.54 millimeters (mm) opening (EFD syringe form Nordson Company). Dispense sample at 25 °C through the opening by applying a pressure of 0.62 MPa to the syringe. The mass of the sample in grams (g) extruded after one minute corresponds to the extrusion rate in g/min. The objective of the present invention is to achieve an extrusion rate of at least 15 g/min.

Notably, some samples were highly viscous pastes that could not be extruded so they are reported as having an ER of 0 (and thermal conductivity was not measured, thus reporting as "NA").

### Thermal Conductivity Test

Determine thermal conductivity (TC) according to ISO 22007-2 using a hot disk. The TC of cured samples was measured by Hot Disk TPS 2500 S instrument with a 3.189 mm Kapton sensor (model 5465). The cured samples were prepared by curing the curable thermally conductive composition samples at 120 °C for 60 min with dimension of 25mm*25mm*8mm. The objective of the present invention is to achieve a TC of greater than 3.0 W/m*K.

### Oil Bleeding Test

A curable thermally conductive composition sample (0.6 mL) was applied on A4 paper and sandwiched by 2 pieces of glass panels with dimensions of 5 cm*5 cm, and the thickness of the sample was adjusted to 1.5 mm with a spacer. Then the initial diameter of the sample (denoted as "D0") was measured. The obtained test specimen was placed horizontally at 25 °C ("RT") for 5 days and at 125 °C for 2 days, respectively. The oil bleeding degree on paper is evaluated as the increment percent between the diameter of the oil that had bled out from the composition (denoted as "D1", i.e., the diameter of circular sample after oil migration) and the initial diameter of the composition (D0): $Oil bleeding degree = \left[\left(D1-D0\right)/D0\right] \times 100 %$

The objective of the present invention is to achieve both oil bleeding requirements of no more than 10% (≤ 10%) after aging at RT for 5 days and after aging at 125 °C for 2 days, respectively.

### Hardness Test

Hardness of cured samples was determined by Durometer Shore A. The cured samples were prepared according to the same procedure described in the Thermally conductivity Test. The highest value was recorded. The objective of the present invention is to achieve a Shore A hardness >5.

Each sample was characterized for ER using the Extrusion Rate Test, TC using the Thermal Conductivity Test, oil bleeding degree using the Oil Bleeding Test, and hardness using the Hardness Test described herein, above.

Table 2 contains characterization results for IEs 1-5 samples. As shown in Table 2, all IEs 1-5 samples achieved requirements of an ER≥ 15 g/min, an oil bleeding degree of ≤ 10% both at 25 °C for 5 days (hereinafter "RT*5D") and at 125 °C for 2 days (hereinafter "125 °C*2D"), and a TC of greater than 3.0 W/m*K.

Table 3 contains characterization results for CEs 1-5 samples. As shown in Table 3, CE 1 sample was preprepared by mixing (A-1) Q-branched vinyl-terminal polymer, (B1-1) SiH crosslinker, and (E-1) Pt catalyst with heating for pre-cure, but no (B2) SiH crosslinker was used for post-cure when application, which failed requirements for ER and oil bleeding degree at RT and 125 °C.

CE 2 sample includes (A-2) linear vinyl-terminal polymer instead of (A-1) Q-branched vinyl-terminal polymer in the pre-curing step provided a much higher oil bleeding degree at RT (e.g., 38%).

CE 3 sample includes (A-1) Q-branched vinyl terminal polymer, (B1-3) SiH crosslinker, (E-1) Pt catalyst with heating for pre-cure but at a high SiH_{B1}/Vi ratio (>0.35), and further includes (B2-4) SiH crosslinker for post cure in application. CE 3 sample showed an ER of 0 g/min (material is too viscous) and thus other properties could not be measured.

CE 4 sample does not include a heating process for pre-cure, instead using (A-2) + (A-3) linear vinyl terminal polymers to replace (A-1) Q-branched vinyl-terminal polymer and adding (B2-3) SiH crosslinker and (E-2) Pt catalyst after filler loading for post-cure when application. CE 4 sample showed a high oil bleeding degree at RT (>10%).

CE 5 sample includes components (A-1) Q-branched vinyl terminal polymer, (B1-3) SiH crosslinker, (C), (D), and (E-1) Pt catalyst at a low SiH_{B1}/Vi ratio (<0.2) with heating process for pre-cure and further includes (B2-2) SiH crosslinker for post cure in application provided a much higher oil bleed degree at RT (> 10%).

**Table 2**

| **Component** | | **IE 1** | **IE 2** | **IE 3** | **IE 4** | **IE 5** |
|---|---|---|---|---|---|---|
| Vinyl Polymer (A) | Q-branched vinyl polymer A-1 | 7.23 | 7.16 | 7.38 | 7.4 | 4.3 |
| SiH crosslinker (B1) | SiH crosslinker B1-1 | | | | 0.105 | |
| | SiH crosslinker B1-2 | 0.440 | 0.440 | | | 0.240 |
| | SiH crosslinker B1-3 | | | 0.330 | | |
| SiH crosslinker (B2) | SiH crosslinker B2-1 | 0.21 | | | 0.295 | |
| | SiH crosslinker B2-2 | | | 0.09 | | 0.06 |
| | SiH crosslinker B2-3 | | 0.27 | | | |
| TC filler (C) | Alumina filler C-1 | 52.4 | 52.4 | 52.4 | 52.4 | 54.0 |
| | Alumina filler C-2 | 26.2 | 26.2 | 26.2 | 26.2 | 27.0 |
| | Zinc oxide filler C-3 | 12.6 | 12.6 | 12.6 | 12.6 | 13.0 |
| Treating agent (D) | Treating agent D-1 | 0.50 | 0.20 | 0.20 | 0.20 | 0.20 |
| | Treating agent D-2 | | 0.60 | 0.60 | 0.60 | 1.00 |
| Pt catalyst (E) | Catalyst E-1 | 0.02 | 0.03 | 0.03 | 0.03 | 0.03 |
| | Catalyst E-2 | 0.10 | | | | |
| Inhibitor (F) | Inhibitor F-1 | 0.10 | 0.10 | 0.12 | 0.12 | 0.10 |
| Pigment (G) | Pigment G-1 | 0.200 | | 0.050 | 0.050 | 0.070 |
| **Characterization** | | | | | | |
| Wt% TC filler | | 91.2 | 91.2 | 91.2 | 91.2 | 94.0 |
| SiH_{B1}/Vi ratio | | 0.275 | 0.277 | 0.302 | 0.230 | 0.251 |
| (SiH_{B1}+SiH_{B2})/Vi ratio | | 0.476 | 0.490 | 0.580 | 0.489 | 0.536 |
| Process | | with heating step | with heating step | with heating step | with heating step | with heating step |
| SiH_{B2} for post-cure | | added | added | added | added | added |
| Oil bleeding degree, RT*5D | | 8.7% | 7.7% | 8.2% | 8.5% | 8.3% |
| Oil bleeding degree, 125 °C*2D | | 2.0% | 2.0% | 2.0% | 2.0% | 2.0% |
| ER (g/min) | | 15 | 18 | 22 | 24 | 21 |
| TC (W/m*K) | | 3.791 | 3.702 | 3.378 | 3.690 | 5.091 |
| Durometer, shore A | | 28 | 18 | 24 | 38 | 29 |

| | | | | | | |
|---|---|---|---|---|---|---|
| *In Tables 2 and Table 3 below:* *"Wt% TC filler" refers to wt% of total thermally conductive fillers relative to the total weight of the curable thermally conductive composition.* *"SiH_{B1}*/*Vi ratio" refers to molar ratio of SiH functionality from the SiH crosslinker (B1) to vinyl functionality from the vinyl polymer (A).* *"(SiH_{B1}+SiH_{B2})lVi ratio" refers to molar ratio of total SiH functionality from the SiH crosslinker (B1) and SiH crosslinker (B2) to vinyl functionality from the vinyl polymer (A).* *"ER", "TC", "Oil bleeding degree" at RT for 5 days and at 120 °C for 2 days, respectively, and "hardness" were evaluated according to the test methods described above.* | | | | | | |

**Table 3**

| **Component** | | **CE 1** | **CE 2** | **CE3** | **CE 4** | **CE 5** |
|---|---|---|---|---|---|---|
| Vinyl Polymer (A) | Q-branched vinyl polymer A-1 | 8.43 | | 7.38 | | 7.53 |
| | Linear vinyl polymer A-2 | | 8.88 | | 1.2 | |
| | Linear vinyl polymer A-3 | | | | 7.5 | |
| SiH crosslinker (B1) | SiH crosslinker B1-1 | 0.111 | 0.170 | | | |
| | SiH crosslinker B1-2 | | | | | |
| | SiH crosslinker B1-3 | | | 0.450 | | 0.200 |
| SiH crosslinker (B2) | SiH crosslinker B2-1 | | 0.200 | | | |
| | SiH crosslinker B2-2 | | | 0.04 | | 0.14 |
| | SiH crosslinker B2-3 | | | | 0.5 | |
| TC filler (C) | Alumina filler C-1 | 58.5 | 58 | 52.4 | 58 | 52.4 |
| | Alumina filler C-2 | 32.3 | 32 | 26.2 | 32 | 26.2 |
| | Zinc oxide filler C-3 | | | 12.6 | | 12.6 |
| Treating agent (D) | Treating agent D-1 | 0.61 | 0.60 | 0.20 | | 0.20 |
| | Treating agent D-2 | | | 0.60 | 0.6 | 0.60 |
| Pt Catalyst (E) | Catalyst E-1 | 0.05 | 0.02 | 0.03 | | 0.03 |
| | Catalyst E-2 | | 0.1 | | 0.15 | |
| Inhibitor (F) | Inhibitor F-1 | | 0.10 | 0.10 | | 0.10 |
| Pigment (G) | Pigment G-1 | | 0.030 | | 0.05 | |
| **Characterization** | | | | | | |
| Wt% TC filler | | 90.8 | 90.0 | 91.2 | 90.0 | 90.0 |
| SiH_{B1}/Vi ratio | | 0.213 | 0.242 | 0.412 | 0 | 0.179 |
| (SiH_{B1}+SiH_{B2})/Vi ratio | | 0.213 | 0.636 | 0.559 | 1.25 | 0.541 |
| Process | | with heating step | with heating step | with heating step | without heating step | with heating step |
| SiH_{B2} for post-cure | | None | added | added | added | added |
| Oil bleeding degree, RT*5D | | 36.0% | 38.0% | 0 | 46.0% | 75.0% |
| Oil bleeding degree, 125 °C*2D | | 51.0% | 2.0% | 0 | 2.0% | 2.0% |
| ER (g/min) | | 13 | 19 | 0 | 52 | 77 |
| TC (W/m*K) | | 3.496 | 3.073 | NA | 3.096 | 3.552 |
| Durometer, shore A | | NA | NA | NA | 14 | 15 |

## Claims

1. A method of making a curable thermally conductive composition, comprising the steps of:
(I) preparing an admixture comprising the following components (A), (B1), (C), (D), and (E):
(A) from 3 weight-percent to 10 weight-percent of a Q-branched alkenyl-functional polyorganosiloxane having at least three terminally alkenyl groups per molecule and having a viscosity of 25 to 2000 milliPascal*seconds, as determined according to ASTM D445-21 using a glass capillary Cannon-Fenske type viscometer at 25 °C;
(B1) a silyl-hydride functional polysiloxane crosslinker that contains at least two silyl-hydride groups per molecule and that is present at a concentration to provide a molar ratio of silicon-bonded hydrogen atoms in the silyl-hydride functional polysiloxane crosslinker (B1) to alkenyl groups in the Q-branched alkenyl-functional polyorganosiloxane (A) in a range of 0.2 to 0.35;
(C) 90 weight-percent or more of a thermally conductive filler;
(D) a filler treating agent; and
(E) a platinum-based hydrosilylation reaction catalyst;
(II) curing the admixture obtained from step (I) by heat, thereby forming a pre-cured composite; and
(III) admixing the pre-cured composite obtained from step (II) with (B2) a silyl-hydride functional polysiloxane crosslinker that contains at least two silyl-hydride groups per molecule; thereby obtaining the curable thermally conductive composition;
wherein a molar ratio of total silicon-bonded hydrogen atoms in the silyl-hydride functional polysiloxane crosslinkers (B1) and (B2) to alkenyl groups in the Q-branched alkenyl-functional polyorganosiloxane (A) is greater than 0.45;
where weight-percentages are relative to the curable thermally conductive composition weight.

2. The method of claim 1, further comprising addition of (F) an inhibitor, (E') an additional platinum-based hydrosilylation reaction catalyst, or mixtures thereof; in step (III) or after step (III).

3. The method of claim 1 or 2, wherein the Q-branched alkenyl-functional polyorganosiloxane (A) has chemical formula (I): 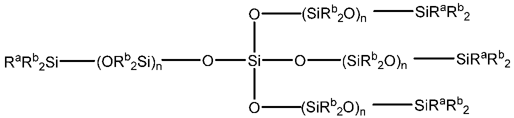 where each R^{a} is independently an alkenyl group, each R^{b} is independently a monovalent hydrocarbon group free of aliphatic unsaturation, and n is an integer of from 15 to 150 representing the average number of the chain length of different branches of the polyorganosiloxane.

4. The method of any one of claims 1-3, wherein the molar ratio of silicon-bonded hydrogen atoms in the silyl-hydride functional polysiloxane crosslinker (B1) to alkenyl groups in the Q-branched alkenyl-functional polyorganosiloxane (A) is in a range of 0.22 to 0.28.

5. The method of any one of claims 1-4, wherein admixing the pre-cured composite with the silyl-hydride functional polysiloxane crosslinker (B2) at step (III) is conducted at temperatures lower than 30 °C.

6. The method of any one of claims 1-5, wherein the crosslinkers (B1) and (B2) each independently have an average chemical structure (IV):
R^{bb}₍₃₋ₕ₎HₕSiO-(HR^{bb}SiO)ₑ-(R^{bb}₂SiO)_{f}-SiH_{h'}R^{bb}_{(3-h')} (IV)
where R^{bb} is independently in each occurrence selected from an alkyl group having from 1 to 6 carbon atoms and phenyl; subscripts h and h' each are independently in each occurrence selected from a value in a range of zero to 3 provided that the combination of e, h, and h' is at least 2; subscript e is zero to 30; and subscript f is 5 to 200.

7. The method of any one of claims 1-6, wherein the thermally conductive filler (C) comprises: (c1) from 40 to 60 wt% of aluminum oxide particles having a D50 of 20 to 50 µm; (c2) from 25 weight-percent to 40 weight-percent of aluminum oxide particles having a D50 of 1 to 5 µm; and (c3) from 10 to 20 weight-percent of zinc oxide particles having a D50 of 0.1 to 0.5 µm; where weight-percentages are relative to the curable thermally conductive composition weight, and D50 is measured according to the method in the description.

8. A curable thermally conductive composition, comprising an admixture of a pre-cured composite with (B2) a silyl-hydride functional polysiloxane crosslinker that contains at least two silyl-hydride groups per molecule;
wherein the pre-cured composite comprises component (C), component (D), and a hydrosilylation reaction product of components (A), (B1), and (E):
(A) from 3 weight-percent to 10 weight-percent of a Q-branched alkenyl-functional polyorganosiloxane having at least three terminally alkenyl groups per molecule and having a viscosity of 25 to 2000 milliPascal*seconds, as determined according to ASTM D445-21 using a glass capillary Cannon-Fenske type viscometer at 25 °C;
(B1) a silyl-hydride functional polysiloxane crosslinker that contains at least two silyl-hydride groups per molecule and that is present at a concentration to provide a molar ratio of silicon-bonded hydrogen atoms in the silyl-hydride functional polysiloxane crosslinker (B1) to alkenyl groups in the Q-branched alkenyl-functional polyorganosiloxane (A) of 0.2 to 0.35;
(C) 90 weight-percent or more of a thermally conductive filler;
(D) a filler treating agent; and
(E) a platinum-based hydrosilylation reaction catalyst;
wherein a molar ratio of total silicon-bonded hydrogen atoms in the silyl-hydride functional polysiloxane crosslinkers (B1) and (B2) to alkenyl groups in the Q-branched alkenyl-functional polyorganosiloxane (A) is greater than 0.45;
where weight-percentages are relative to the curable thermally conductive composition weight;
wherein the curable thermally conductive composition has an extrusion rate of 15 grams per minute or more and an oil bleeding degree of no more than 10% at 25 °C for 5 days and after aging at 125 °C for 2 days, respectively, and cures into a material having a thermal conductivity of greater than 3.0 Watts per meter*Kelvin according to ISO 22007-2 using a hot disk.

9. A process for forming a thermally conductive silicone material on an electronic component, comprising:
(i) providing the curable thermally conductive composition of claim 8,
(ii) applying the curable thermally conductive composition on the electronic component, and
(iii) curing the curable thermally conductive composition by heat; thereby forming the thermally conductive silicone material.

10. The process of claim 9, wherein the applying of the curable thermally conductive composition involves dispensing the curable thermally conductive composition.

## Patentansprüche

1. Verfahren zum Erzeugen einer härtbaren wärmeleitfähigen Zusammensetzung, umfassend die Schritte:
(I) Herstellen eines Gemischs, umfassend die folgenden Komponenten (A), (B1), (C), (D) und (E):
(A) von zu 3 Gewichtsprozent bis 10 Gewichtsprozent ein Q-verzweigtes alkenylfunktionelles Polyorganosiloxan, das mindestens drei endständige Alkenylgruppen pro Molekül aufweist und eine Viskosität von 25 bis 2000 Millipascal*Sekunden aufweist, wie gemäß ASTM D445-21 unter Verwendung eines Glaskapillarviskosimeters vom Typ Cannon-Fenske bei 25 °C bestimmt;
(B1) einen silylhydridfunktionellen Polysiloxanvernetzer, der mindestens zwei Silylhydridgruppen pro Molekül enthält und der in einer Konzentration vorhanden ist, um ein Molverhältnis von siliciumgebundenen Wasserstoffatomen in dem silylhydridfunktionellen Polysiloxanvernetzer (B1) zu Alkenylgruppen in dem Q-verzweigten alkenylfunktionellen Polyorganosiloxan (A) in einem Bereich von 0,2 bis 0,35 bereitzustellen;
(C) zu 90 Gewichtsprozent oder mehr einen wärmeleitfähigen Füllstoff;
(D) ein Füllstoffbehandlungsmittel; und
(E) einen Hydrosilylierungsreaktionskatalysator auf Platinbasis;
(II) Härten des Gemischs, das aus Schritt (I) erhalten wird, durch Hitze, wobei dadurch ein vorgehärteter Verbundwerkstoff ausgebildet wird; und
(III) Vermischen des vorgehärteten Verbundwerkstoffs, der aus Schritt (II) erhalten wird, mit (B2) einem silylhydridfunktionellen Polysiloxanvernetzer, der mindestens zwei Silylhydridgruppen pro Molekül enthält; wobei dadurch die härtbare wärmeleitfähige Zusammensetzung erhalten wird;
wobei ein Molverhältnis der gesamten siliciumgebundenen Wasserstoffatome in den silylhydridfunktionellen Polysiloxanvernetzern (B1) und (B2) zu Alkenylgruppen in dem Q-verzweigten alkenylfunktionellen Polyorganosiloxan (A) größer als 0,45 ist;
wobei sich die Gewichtsprozente auf das Gewicht der härtbaren wärmeleitfähigen Zusammensetzung beziehen.

2. Verfahren nach Anspruch 1, ferner umfassend ein Zusetzen von (F) einem Inhibitor, (E') einem zusätzlichen Hydrosilylierungsreaktionskatalysator auf Platinbasis oder Mischungen davon; in Schritt (III) oder nach Schritt (III).

3. Verfahren nach Anspruch 1 oder 2, wobei das Q-verzweigte alkenylfunktionelle Polyorganosiloxan (A) eine chemische Formel (I) aufweist: 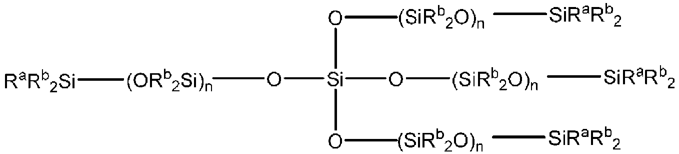 wobei jedes R^{a} unabhängig voneinander eine Alkenylgruppe ist, jedes R^{b} unabhängig voneinander eine einwertige Kohlenwasserstoffgruppe frei von aliphatischer Ungesättigtheit ist und n eine ganze Zahl von 15 bis 150, die die durchschnittliche Zahl der Kettenlänge verschiedener Verzweigungen des Polyorganosiloxans darstellt, ist.

4. Verfahren nach einem der Ansprüche 1 bis 3, wobei das Molverhältnis von siliciumgebundenen Wasserstoffatomen in dem silylhydridfunktionellen Polysiloxanvernetzer (B1) zu Alkenylgruppen in dem Q-verzweigten alkenylfunktionellen Polyorganosiloxan (A) in einem Bereich von 0,22 bis 0,28 liegt.

5. Verfahren nach einem der Ansprüche 1 bis 4, wobei das Vermischen des vorgehärteten Verbundwerkstoffs mit dem silylhydridfunktionellen Polysiloxanvernetzer (B2) in Schritt (III) bei Temperaturen von unter 30 °C durchgeführt wird.

6. Verfahren nach einem der Ansprüche 1 bis 5, wobei die Vernetzer (B1) und (B2) jeweils unabhängig voneinander eine durchschnittliche chemische Struktur (IV) aufweisen:
R^{bb}₍₃₋ₕ₎HₕSiO-(HR^{bb}SiO)ₑ-(R^{bb}₂SiO)_{f}-SiH_{h'}^{bb}_{(3-h')} (IV)
wobei R^{bb} unabhängig bei jedem Auftreten aus einer Alkylgruppe, die von 1 bis 6 Kohlenstoffatome aufweist, und Phenyl ausgewählt ist; die Indizes h und h' jeweils bei jedem Auftreten unabhängig voneinander aus einem Wert in einem Bereich von null bis 3 ausgewählt sind, mit der Maßgabe, dass die Kombination von e, h und h' mindestens 2 beträgt; der Index e null bis 30 beträgt; und der Index f 5 bis 200 beträgt.

7. Verfahren nach einem der Ansprüche 1 bis 6, wobei der wärmeleitfähige Füllstoff (C) umfasst: (c1) von zu 40 bis 60 Gew.-% Aluminiumoxidteilchen, die eine D50 von 20 bis 50 µm aufweisen; (c2) von zu 25 Gewichtsprozent bis 40 Gewichtsprozent Aluminiumoxidteilchen, die eine D50 von 1 bis 5 µm aufweisen; und (c3) von zu 10 bis 20 Gewichtsprozent Zinkoxidteilchen, die eine D50 von 0,1 bis 0,5 µm aufweisen; wobei sich die Gewichtsprozente auf das Gewicht der härtbaren wärmeleitfähigen Zusammensetzung beziehen und D50 gemäß dem Verfahren in der Beschreibung gemessen wird.

8. Härtbare wärmeleitfähige Zusammensetzung, umfassend ein Gemisch eines vorgehärteten Verbundwerkstoffs mit (B2) einem silylhydridfunktionellen Polysiloxanvernetzer, der mindestens zwei Silylhydridgruppen pro Molekül enthält;
wobei der vorgehärtete Verbundwerkstoff Komponente (C), Komponente (D) und ein Hydrosilylierungsreaktionsprodukt der Komponenten (A), (B1) und (E) umfasst:
(A) von zu 3 Gewichtsprozent bis 10 Gewichtsprozent ein Q-verzweigtes alkenylfunktionelles Polyorganosiloxan, das mindestens drei endständige Alkenylgruppen pro Molekül aufweist und eine Viskosität von 25 bis 2000 Millipascal*Sekunden aufweist, wie gemäß ASTM D445-21 unter Verwendung eines Glaskapillarviskosimeters vom Typ Cannon-Fenske bei 25 °C bestimmt;
(B1) einen silylhydridfunktionellen Polysiloxanvernetzer, der mindestens zwei Silylhydridgruppen pro Molekül enthält und der in einer Konzentration vorhanden ist, um ein Molverhältnis von siliciumgebundenen Wasserstoffatomen in dem silylhydridfunktionellen Polysiloxanvernetzer (B1) zu Alkenylgruppen in dem Q-verzweigten alkenylfunktionellen Polyorganosiloxan (A) von 0,2 bis 0,35 bereitzustellen;
(C) zu 90 Gewichtsprozent oder mehr einen wärmeleitfähigen Füllstoff;
(D) ein Füllstoffbehandlungsmittel; und
(E) einen Hydrosilylierungsreaktionskatalysator auf Platinbasis;
wobei ein Molverhältnis der gesamten siliciumgebundenen Wasserstoffatome in den silylhydridfunktionellen Polysiloxanvernetzern (B1) und (B2) zu Alkenylgruppen in dem Q-verzweigten alkenylfunktionellen Polyorganosiloxan (A) größer als 0,45 ist;
wobei sich die Gewichtsprozente auf das Gewicht der härtbaren wärmeleitfähigen Zusammensetzung beziehen;
wobei die härtbare wärmeleitfähige Zusammensetzung eine Extrusionsrate von 15 Gramm pro Minute oder mehr und einen Ölausblutungsgrad von nicht mehr als 10 % bei 25 °C für 5 Tage beziehungsweise nach Alterung bei 125 °C für 2 Tage aufweist und zu einem Material, das eine Wärmeleitfähigkeit von größer als 3,0 Watt pro Meter*Kelvin gemäß ISO 22007-2 unter Verwendung einer Hot Disk aufweist, aushärtet.

9. Prozess zum Ausbilden eines wärmeleitfähigen Siliconmaterials auf einer elektronischen Komponente, umfassend:
(i) Bereitstellen der härtbaren wärmeleitfähige Zusammensetzung nach Anspruch 8,
(ii) Aufbringen der härtbaren wärmeleitfähigen Zusammensetzung auf die elektronische Komponente, und
(iii) Härten der härtbaren wärmeleitfähigen Zusammensetzung durch Hitze; wobei dadurch das wärmeleitfähige Siliconmaterial ausgebildet wird.

10. Prozess nach Anspruch 9, wobei das Aufbringen der härtbaren wärmeleitfähigen Zusammensetzung ein Ausgeben der härtbaren wärmeleitfähigen Zusammensetzung beinhaltet.

## Revendications

1. Procédé de fabrication d'une composition thermoconductrice durcissable, comprenant les étapes consistant à :
(I) préparer un mélange comprenant les composants (A), (B1), (C), (D) et (E) suivants :
(A) de 3 % en poids à 10 % en poids d'un polyorganosiloxane à fonctionnalité alcényle à ramification Q ayant au moins trois groupes alcényles terminaux par molécule et ayant une viscosité de 25 à 2000 milliPascal*secondes, telle que déterminée selon la norme ASTM D445-21 à l'aide d'un viscosimètre à capillarité en verre de type Cannon-Fenske à 25 °C ;
(B1) un agent de réticulation de polysiloxane à fonctionnalité silyle-hydrure qui contient au moins deux groupes silyl-hydrure par molécule et qui est présent à une concentration permettant d'obtenir un rapport molaire d'atomes d'hydrogène liés à du silicium dans l'agent de réticulation de polysiloxane à fonctionnalité silyle-hydrure (B1) à des groupes alcényle dans le polyorganosiloxane à fonctionnalité alcényle ramifié Q (A) dans une plage de 0,2 à 0,35 ;
(C) 90 pour cent en poids ou plus de charge thermoconductrice ;
(D) un agent de traitement de charge ; et
(E) un catalyseur de réaction d'hydrosilylation à base de platine ;
(II) durcir le mélange obtenu à l'étape (I) par la chaleur, formant ainsi un composite pré-durci ; et
(III) mélanger le composite prédurci obtenu à l'étape (II) avec (B2) un agent de réticulation de polysiloxane à fonctionnalité silyle-hydrure qui contient au moins deux groupes silyl-hydrure par molécule ; obtenant ainsi la composition thermoconductrice durcissable ;
dans lequel une rapport molaire de atomes d'hydrogène totale liée à du silicium dans les agents de réticulation de polysiloxane à fonctionnalité silyle-hydrure (B1) et (B2) à groupes alcényle dans la polyorganosiloxane à fonctionnalité alcényle ramifiée Q (A) est supérieure à 0,45 ;
où le pourcentage en poids est relatif au poids de composition thermoconductrice durcissable.

2. Procédé selon la revendication 1, comprenant en outre l'ajout de (F) un inhibiteur, (E') un catalyseur de réaction d'hydrosilylation à base de platine supplémentaire, ou des mélanges de ceux-ci ; à l'étape (III) ou après l'étape (III).

3. Procédé selon la revendication 1 ou 2, dans lequel le polyorganosiloxane à fonction alcényle Q (A) a la formule chimique (I) : 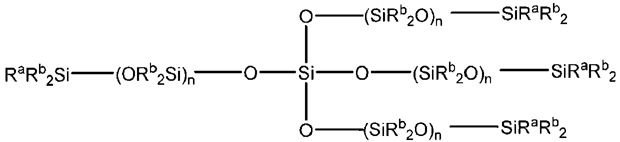 où chaque R^{a} est indépendamment un groupe alcényle, chaque R^{b} est indépendamment un groupe hydrocarboné monovalent exempt d'insaturation aliphatique, et n est un nombre entier allant de 15 à 150 représentant le nombre moyen de la longueur de chaîne des différentes ramifications du polyorganosiloxane.

4. Procédé selon l'une quelconque des revendications 1 à 3, dans lequel l'rapport molaire de atomes d'hydrogène lié à du silicium dans l'agent de réticulation de polysiloxane à fonction hydrure de silyle (B1) pour groupes alcényle dans l'polyorganosiloxane à fonctionnalité alcényle ramifiée Q (A) est dans une plage de 0,22 à 0,28.

5. Procédé selon l'une quelconque des revendications 1 à 4, dans lequel le mélange du composite prédurci avec l'agent de réticulation polysiloxane fonctionnel silyle-hydrure (B2) à l'étape (III) est effectué à des températures inférieures à 30 °C.

6. Procédé selon l'une quelconque des revendications 1 à 5, dans lequel les agents de réticulation (B1) et (B2) ont chacun indépendamment une structure chimique moyenne (IV) :
R^{bb}₍₃₋ₕ₎HₕSiO-(HR^{bb}SiO)ₑ-(R^{bb}₂SiO)_{f}-SiH_{h'}R^{bb}_{(3-h')} (IV)
où R^{bb} est indépendamment dans chaque occurrence choisi parmi un groupe alkyle ayant de 1 à 6 atomes de carbone et un phényle ; les indices h et h' sont chacun indépendamment dans chaque occurrence choisis parmi une valeur dans une plage de zéro à 3 à condition que la combinaison de e, h et h' vaille au moins 2 ; l'indice e vaut de zéro à 30 ; et l'indice f va de 5 à 200.

7. Procédé selon l'une quelconque des revendications 1 à 6, dans lequel la charge thermoconductrice (C) comprend : (c1) de 40 à 60 % en poids de particules d'oxyde d'aluminium ayant un D50 de 20 à 50 µm ; (c2) de 25 pour cent en poids à 40 pour cent en poids de particules d'oxyde d'aluminium ayant un D50 de 1 à 5 µm ; et (c3) de 10 à 20 pour cent en poids de particules d'oxyde de zinc ayant un D50 de 0,1 à 0,5 µm ; où les pourcentages en poids sont relatifs au poids de la composition thermoconductrice durcissable, et D50 est mesuré selon le procédé dans la description.

8. Composition thermiquement conductrice durcissable, comprenant un mélange d'un composite prédurci avec (B2) un agent de réticulation polysiloxane à fonctionnalité silyle-hydrure qui contient au moins deux groupes silyle-hydrure par molécule ;
dans lequel le composite prédurci comprend le composant (C), le composant (D) et un produit de réaction d'hydrosilylation des composants (A), (B1) et (E) :
(A) de 3 % en poids à 10 % en poids d'un polyorganosiloxane à fonctionnalité alcényle à ramification Q ayant au moins trois groupes alcényles terminaux par molécule et ayant une viscosité de 25 à 2000 milliPascal*secondes, telle que déterminée selon la norme ASTM D445-21 à l'aide d'un viscosimètre à capillarité en verre de type Cannon-Fenske à 25 °C ;
(B1) un agent de réticulation de polysiloxane à fonctionnalité silyle-hydrure qui contient au moins deux groupes silyl-hydrure par molécule et qui est présent à une concentration permettant d'obtenir un rapport molaire d'atomes d'hydrogène liés à du silicium dans l'agent de réticulation de polysiloxane à fonctionnalité silyle-hydrure (B1) à des groupes alcényle dans le polyorganosiloxane à fonctionnalité alcényle ramifié Q (A) de 0,2 à 0,35 ;
(C) 90 pour cent en poids ou plus de charge thermoconductrice ;
(D) un agent de traitement de charge ; et
(E) un catalyseur de réaction d'hydrosilylation à base de platine ;
dans lequel une rapport molaire de atomes d'hydrogène totale liée à du silicium dans les agents de réticulation de polysiloxane à fonctionnalité silyle-hydrure (B1) et (B2) à groupes alcényle dans la polyorganosiloxane à fonctionnalité alcényle ramifiée Q (A) est supérieure à 0,45 ;
où les pourcentages en poids sont relatifs au poids de composition thermoconductrice durcissable ;
dans laquelle la composition thermiquement conductrice durcissable a un taux d'extrusion de 15 grammes par minute ou plus et un degré de saignement de l'huile ne dépassant pas 10 % à 25 °C pendant 5 jours et après un vieillissement à 125 °C pendant 2 jours, respectivement, et durcit en un matériau ayant une conductivité thermique supérieure à 3,0 watts par mètre*Kelvin selon la norme ISO 22007-2 à l'aide d'un disque chaud.

9. Procédé de formation d'un matériau de silicone thermoconducteur sur un composant électronique, comprenant :
(i) la fourniture de la composition thermoconductrice durcissable selon la revendication 8, comprenant :
(ii) l'application de la composition thermoconductrice durcissable sur le composant électronique, et
(iii) durcir la composition thermoconductrice durcissable par la chaleur ; formant ainsi le matériau en silicone thermoconducteur.

10. Procédé selon la revendication 9, dans lequel l'application de la composition thermoconductrice durcissable implique la distribution de la composition thermoconductrice durcissable.
